# EUROPEAN PATENT APPLICATION

(11) **EP 4 145 964 A1**
(43) Date of publication of application: **08.03.2023**
(21) Application number: 22192237.0
(22) Date of filing: 25.08.2022
(51) Int. Cl.: H05K 3/06, H05K 3/18

(54) **COMPONENT CARRIER ETCHING SYSTEM WITH PHYSICALLY SEPARATED ETCHING MODULES, AND COMPONENT CARRIER**

(30) Priority: 01.09.2021 DE 102021122646
(71) Applicant: AT & S Austria Technologie & Systemtechnik Aktiengesellschaft, 8700 Leoben-Hinterberg (AT)
(72) Inventor: Christandl, Robert, 8700 Leoben (AT); Kristl, Thomas, 8793 Trofaiach (AT)
(74) Representative: Dilg, Haeusler, Schindelmann Patentanwaltsgesellschaft mbH

(57) **Abstract**

There is described an etching system (100) for component carrier manufacturing, comprising:
i) a first etching module (110) having:
ia) a first control unit (115) for applying a first etching scheme;
ib) a first inlet (116) for a first supply; and
ic)a first outlet (118) for a first drain; and

ii) a second etching module (120), having:
iia) a second control unit (125) for applying a second etching scheme;
iib) a second inlet (126) for a second supply; and
iic) a second outlet (128) for a second drain.

The first etching module (110) and the second etching module (120) are physically separated, one etching module (110, 120) is arranged process-downstream to the other etching module (110, 120), and the first etching module (110) and the second etching module (120) are communicatively coupled.

Further, a component carrier manufacture system, a method of etching, a component carrier, and a process control device are described.

## Description

### Technical Field

The invention relates to an etching system for component carrier manufacturing. Further, the invention relates to a component carrier manufacturing system that comprises the etching system. The invention further relates to a method of etching a component carrier preform in a component carrier manufacture. The invention also relates to a component carrier (manufactured by the method). Additionally, the invention relates to a process control device and a computer program product.

Thus, the invention may relate to the technical field of manufacturing a component carrier such as a printed circuit board or an IC substrate.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

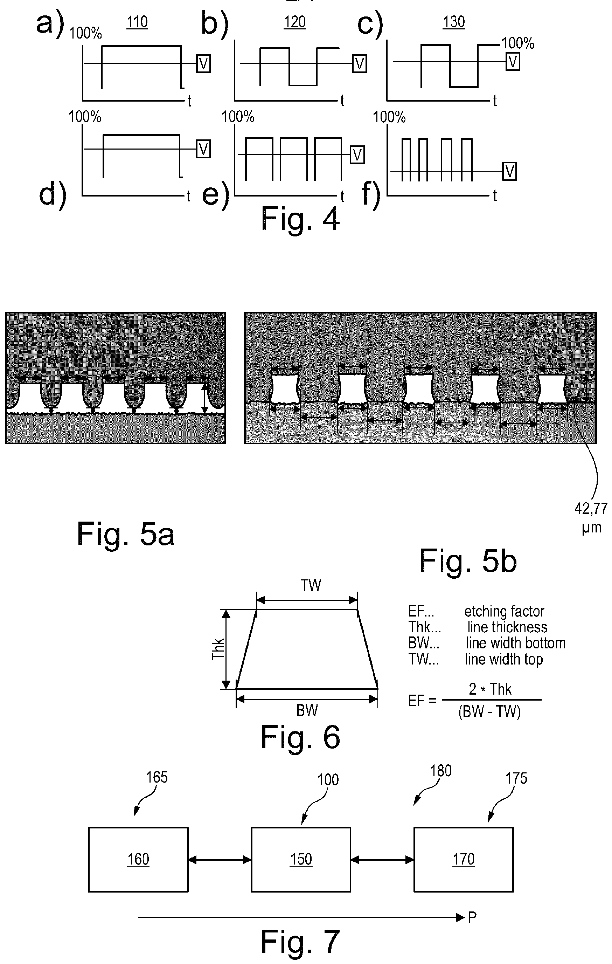

In particular, accurately etching a component carrier preform, such as a panel with a panel format (e.g. rectangular), during manufacture may be considered a challenge. An accurate etching may be described for example by an etching factor, which is illustrated in **Figure 6****.** After etching a copper layer, an etched (trapezoidal) copper structure can be described by the etching factor EF as follows: two times the line thickness (Thk, height) divided by the line width top (TW) subtracted from the line width bottom (BW): EF = (2^{∗}Thk) / (BW - TW). For example, an etching factor of fifteen or more may be considered as accurate, depending on the manufacture circumstances.

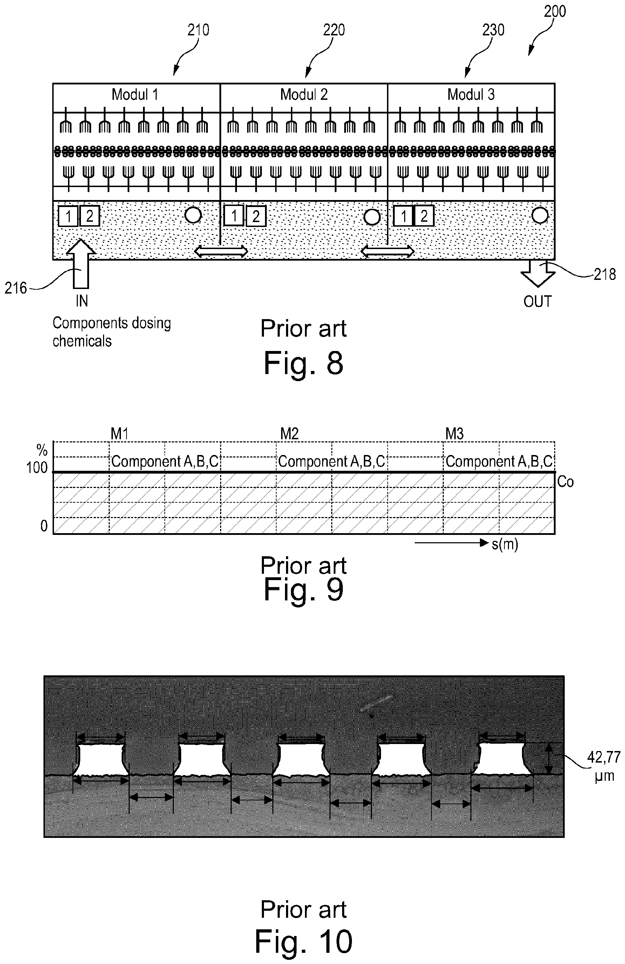

Conventionally, etching in component carrier manufacture is done in an etching module that comprises a number of sub-modules. **Figure 8** shows an example of a conventional etching module 200. The sub-modules 210, 220, 230 are all physically connected, i.e. the etching baths of all three sub-modules are interconnected and there is one common inlet 216 as well as one common outlet 218 for all sub-modules. A panel to be etched is transported by a conveyor belt through all three sub-modules. The etching process is shown as an application of etching solution (from the common etching bath) from above and from below the conveyor belt.

**Figure 9** shows a conventional example of the common etching bath from Figure 8. It can be seen that the chemical composition (in this case substances A, B, and C) is the same in the whole bath 200. Thus, the etching solution is essentially always the same. Dosing is done through the common inlet 216 and the common outlet 218. Accordingly, parameters such as temperature, pressure, pH, etc. are all the same in the sub-modules 210, 220, 230 of the conventional etching module 200.

**Figure 10** illustrates a panel etched by the conventional method described above. Copper structures after etching show an etching factor of around 3, which may be not accurate enough for a plurality of specific component carrier applications. Especially signal transmission may be limited by the achieved structure of the copper traces.

Thus, the overall reliability of component carriers may be increased when the etching factor could be increased. Moreover, the L/S (line/space) ratio and the height/width ratio may thereby be further increased (e.g. to one).

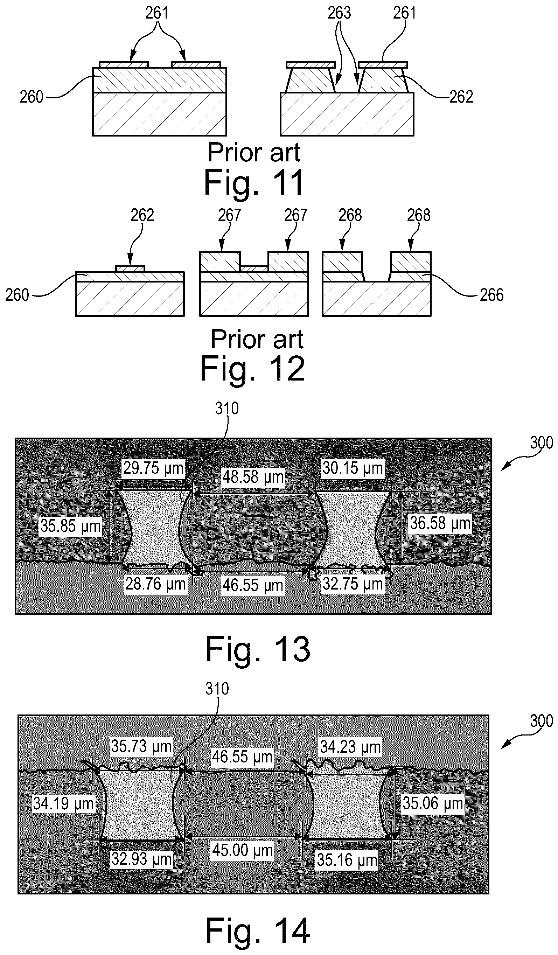

**Figure 11** shows an example of a conventional subtractive manufacturing process. The subtractive process starts from a thick copper foil 260 on which a circuit diagram is applied by means of a photo-structurable polymer (photoresist) 261. After exposure and development, the photoresist 261 maps the actual circuit diagram and protects the conductor traces from etching (= photo process). In the next step, the unprotected copper sites are removed/etched (i.e. in a subtractive manner). Finally, the resist 261 is removed and the conductor traces 262 are obtained.

Since more copper is removed directly under the resist 261 during the etching step, the typical oblique shape ("under-etch" 263) of the conductor trace 262 is obtained. In order to reduce this effect, inhibitors can be applied. These are functionalized polymers that protect the conductor traces 262 from under-etch effects by adhering the functional group of the polymer to the metal surface of the flanks and thus preventing the etching fluid from further etching the conductor trace 262.

**Figure 12** shows an example of a conventional mSAP (modified semi-additive process). The mSAP process starts from a thin copper foil 265, which is used as a seed layer 266. Again, a photoresist 261 is applied and exposed, followed by removing unwanted resist. This process is the same as before in the subtractive process, however, while in the subtractive process the conductor traces are protected, the mSAP process the spaces between the conductor traces are protected. In the non-protected area, copper 267 is then built up by means of electro-plating (additive) and yields the conductor traces 268. It should be noted that the conductor traces 268 are still connected to the thin seed layer 266.

The additive process may be seen as being advantageous with respect to copper trace accuracy. Since there is no intensive etching applied, there is also no pronounced under-etch. In general, an additive process is more precise because the copper is not removed but built up instead. This means that copper traces manufactured by additive process can comprise higher etching factors and higher line/space ratios than copper traces manufactured by the subtractive manufacture process.

Nevertheless, the subtractive manufacture process is still the dominant technology in the industry and may be considered as being significantly more cost-efficient.

### Summary of the Invention

There may be a need to etch a component carrier preform in an accurate and cost-efficient manner.

An etching system, a component carrier manufacture system, a method of etching, a use, a component carrier, a process control device, and a computer program product according to the independent claims are provided.

According to an aspect of the invention, there is described an etching system for component carrier manufacturing, the system comprising (at least two etching modules):
i) a first etching module (for etching a component carrier preform) having:
   ia) a first control unit for applying a first etching scheme,
   ib) a first inlet for a first (chemical) supply (to a first etching bath), and
   ic) a first outlet for a first (chemical) drain (from the first etching bath), and
ii) a second etching module, having:
   iia) a second control unit for applying a second etching scheme,
   iib) a second inlet for a second supply (to a second etching bath), and
   iic) a second outlet for a second drain (from the second etching bath).
   In particular, the first etching module and the second etching module are physically (and/or chemically) separated (and controllable independent of each other). The one (e.g. the second) etching module is arranged process-downstream to the other (e.g. the first) etching module (e.g. a component carrier preform to be etched enters the second module after being etched by the first module). Further, the first etching module and the second etching module are communicatively coupled.

According to a further aspect of the invention, there is described a component carrier manufacture system, comprising:
i) an etching system as described above, comprising an etching central control unit that (communicatively) couples the first control unit and the second control unit, and at least one further process system (with a further control unit coupled to the etching central control unit), in particular at least one of the following:
ii) a galvanic system (process) upstream of the etching system, comprising a galvanic control unit,
iii) a lamination system (process) downstream of the etching system comprising a lamination control unit.
The etching control unit is preferably coupled with the galvanic control unit and/or the lamination control unit.

According to a further aspect of the invention, there is described a use (method of using) of physically (and/or chemically) separated and communicatively coupled etching modules to obtain a specific etching factor (of at least 15, in particular at least 50) in a component carrier preform or component carrier using a subtractive manufacture process (in particular by providing at least one additive, in particular an inhibitor, individually to the etching modules).

According to a further aspect of the invention, there is described a method of etching a component carrier preform in a component carrier manufacture, the method comprises:
i) providing the preform to a first etching module, thereby
ia) applying a first etching scheme, and
ib) supplying and/or draining the first etching module, and then
ii) providing the preform to a second etching module, thereby
iia) applying a second etching scheme, and
iib) supplying and/or draining the second etching module,
wherein the first etching module and the second etching module are physically separated, and wherein the first etching module and the second etching module are communicatively coupled.

According to a further aspect of the invention, there is described a component carrier, manufactured by a subtractive manufacture process (e.g. using the etching system or the method described above), comprising:
i) a plurality of electrically insulating layer structures and/or electrically conductive layer structures, and
ii) at least one, in particular a plurality of, metal trace(s), wherein the (plurality of) metal trace(s) comprise(s) an etching factor of 25 or more, in particular 50 or more, more in particular 70 or more.
The component carrier (has been manufactured using a subtractive process and) is free of a seed layer that reflects a semi-additive process (SAP).

According to a further aspect of the invention, there is described a process control device for regulating the above described systems and/or method. The process control device comprises:
i) a database for capturing at least one process parameter (and an actual value, respectively), in particular a plurality of process parameters, from the running process,
ii) a data model unit which is adapted for storing at least one predetermined process parameter (and a target value, respectively), in particular a plurality of predetermined process parameters, and
iii) a calculation device which is adapted for
   a) comparing the captured process parameter with the predetermined process parameter (and the pluralities with each other, respectively),
   b) determining a control operation which is based on the result of the comparison (for example actively compensating a difference between the actual value and the target value), and
   c) performing the predetermined control operation (e.g. adapt a flow rate, etc.).

According to a further aspect of the invention, there is described a computer program product for controlling/regulating manufacture of a component carrier, which computer program product, when it is executed by one or more processors (and one or more computers, respectively), controls the method (as described above) and/or the systems (as described above) and/or the process control device (as described above).

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers. The term "component carrier preform" may refer to a semi-finished product that will result, after several process steps, in a final component carrier. A preform may e.g. be a panel that comprises a plurality of (semi-finished) component carriers that will be separated in a further manufacturing step.

In this document, the term "etching (process)" may in particular denote a process of the component carrier, in particular circuit board and/or substrate manufacture, which comprises an etching of metal, in particular copper, to thereby provide a desired metallic (electrically conductive) structure.

According to an exemplary embodiment, this (subtractive manufacture) process may be performed as follows, using a positive photoresist or a negative photoresist:
A negative photoresist protects copper paths which shall not be etched away, while copper areas which shall be etched away are not covered with the photoresist. At first, for this purpose, the entire copper layer is coated with the photoresist. Then, through a mask, the photoresist is developed by UV-light. The mask passes UV-light only at positions, where the photoresist shall remain (i.e. where the desired conductor traces shall be provided). During developing, the resist (and the polymer, respectively) is cross-linking at the positions which have been exposed to UV-light. After developing, the photoresist which was not exposed (and not developed, respectively) can be easily washed away. Subsequently, the panel (and the component carrier preform, respectively) is etched. The photoresist protects the conductor traces, while the copper, which is not covered with photoresist, is etched/removed. When the etching process is finished, the photoresist is removed and peeled off, respectively (the resist is cross-linked and solid), and the conductor traces remain.

In the case of a positive photoresist, after lamination of a positive photoresist, a mask is applied to expose the resist to UV light. But this time, during the exposure, parts of the polymer are chemically converted, leading to an enhanced solubility of the original photoresist. Therefore, during the developing step, the exposed parts are washed away.

According to an exemplary example, etching may be done by using an etching solution from an etching bath. The etching solution may comprise copper (cupric) chloride (CuCl₂) and the etching reaction is as follows:
CuCl₂ + Cu -> 2 CuCl (cuprous chloride). Hereby, copper chloride may be mixed with water and/or hydrochloric acid. Further, an additive such as inhibiting agents (e.g. a polymer), wetting agents, brightener, etc. may be used. In another example, iron (III) chloride may be used for etching as follows: Cu + 2 FeCl₃ -> CuCl₂ + 2 FeCl₂. In another example, copper nitrate and ammonium chloride may be used.

In this document, the term "subtractive manufacture process" may refer to a process of forming metal traces in a component carrier (preform) that applies etching of a (thick) copper layer (see e.g. Figure 11 and description of etching above).

In this document, the term "semi-additive manufacture process" may refer to a process of forming metal traces in a component carrier (preform) that applies a thin seed layer and builds up the copper traces on the seed layer (using plating) (see e.g. Figure 12 and description of etching above).

A component carrier (preform) may be identified as being manufactured using the subtractive process or the semi-additive process by the presence of the seed layer.

In this document, the term "etching module" may refer to any device suitable for etching a component carrier preform. In particular, a metal (e.g. copper) surface is etched to yield electrically conductive (layer) structures such as conductor traces. An etching module may comprise a transport element, such as a conveyor belt, for transporting the component carrier preform. Further, an etching module may comprise etching means (e.g. valves and/or nozzles) for applying an etching solution to the preform surface. The etching solution may be stored/prepared in an etching bath within a volume of the etching module. In an embodiment, an etching module may comprise an inlet for supplying (in particular chemicals) to the etching bath. In a further embodiment, an etching module may comprise an outlet for draining (in particular chemicals) from the etching bath. Preferably, the etching parameters and/or the chemical composition in an etching bath may be controlled and/or regulated (by a control unit).

In an example, an etching system comprises a plurality of etching modules arranged in a process direction. Hereby, the component carrier preform passes from one module to the next module. Preferably, the etching modules are independent and physically separated, so that each etching modules can be individually controlled/regulated. For this purpose, a "control unit" may be applied. A control unit may be any electric device and/or software suitable for controlling/regulating at least one parameter of an etching module. The control unit may be part of the etching module or may operate from remote.

In this document, the term "etching scheme" may in particular refer to a control/regulation plan or program for operating an etching module. An etching scheme may be used by a (etching module) control unit to perform etching operations. For example, an etching scheme may contain specific parameters regarding at least one of temperature, pressure, flow velocity, pH, redox factor etc. Further, an etching scheme may contain information/requirements regarding a chemical composition, e.g. concentration of acid, water, copper etc. (in the etching bath). Furthermore, an etching scheme may refer to the presence of a specific additive such as an inhibitor. In an example, the etching modules of an etching system comprise different etching schemes. For example, in a system with three modules, an inhibitor may only be added to the last module. In another example, the temperature may be raised from the first to the last module. In a further example, a chemical concentration may be higher in the first than in the last module. In an example, the first etching scheme comprises a pre-etching, a second etching scheme comprises an (acid) etching, and a third etching scheme comprises addition of an inhibitor (fine-tuning).

In this document, the term "physically separated" may in particular refer to the circumstance that two etching modules can be operated in an independent manner. For example, one module is operated with a first etching scheme and the other module is operated with a second etching scheme. For this purpose, each module may comprise its own inlet and outlet. Accordingly, a first etching bath of a first module and a second etching bath from a second module do (essentially) not mix (there is no interconnection). The etching modules may be spatially separated. However, the etching modules may also be placed next to each other with physical contact (e.g. with a separation wall). In this case, they are still physically separated, because each module comprises its own control unit/scheme and its own supply/drain, so that an independent operation is enabled. In an example, it may (additionally or alternatively) by said that the etching modules are chemically separated since the first etching bath (and etching solution) and the second etching bath (and etching solution) do not mix and can operate independent from each other.

In an embodiment, the first bath comprises a first etching solution and the second bath comprises a second etching solution, wherein the first etching solution is different (in particular in the chemical composition) from the second etching solution. In a further embodiment, each module comprises a different chemical composition of the etching solution in the respective etching bath.

In this document, the term "communicatively coupled" may refer to the circumstance that information between etching modules, in particular between control units of the etching modules, are exchanged (one way or two-way). Communication may be established, e.g. with cable, WiFi, Bluetooth, etc.). In this manner, information (in particular measurement data) may be provided from one etching module to another etching module. Thereby, the etching process may be efficiently coordinated. Such information may include for example: panel present? which panel? redox factor correct? flow-through in operation? exact chemical dosing? etc. (see also description of etching scheme parameters in the following).

In the context of the present document, the term "lamination process" may refer to an after-etching process, wherein at least two layers are laminated together. The process may involve the application of pressure (lamination and pressure process) to ensure, that resin flows inside the recesses of the metal traces. Thereby the metal traces may be fully covered with a dielectric material. To ensure high reliability of the produced component carrier, theses recesses may be fully filled without voids. The lamination process may also be termed "re-lamination" or "hot press".

In the context of this document, the term "process control device" may in particular denote any device (or plurality of devices) which are suitable for performing a process control, wherein the process (at least partially) concerns a circuit board and/or substrate manufacture. In particular, the process control device is adapted to (at least partially) control and regulate, a component carrier manufacture. For this purpose, the process control device in particular may comprise a database (unit) and a data model unit, wherein the former stores captured processed data, while the latter stores intended desired process data. The process control device may be coupled with a multiplicity of sensors and measuring devices, to determine actual parameters at different process stations in this manner. Furthermore, the process control device may comprise a calculation device which compares the captured parameters with the desired ones and, based thereon, determines and performs a control operation. In a preferred embodiment, the process control device comprises a self-learning algorithm (AI) by which controlling and regulating, respectively, of the process can be continuously improved.

According to an exemplary embodiment, the invention may be based on the idea that a component carrier preform may be etched in an accurate (reliable) and cost-efficient manner, when an etching system comprises at least two physically separated etching modules that may be operated according to different etching schemes, that may be supplied/drained by different inlets/outlets, and that are communicatively coupled (i.e. there is a feedback functionality).

Conventionally, there is provided one large etching module in component carrier manufacturing that contains several physically and chemically connected sub-modules. Physical and chemical parameters are more or less the same in the sub-modules since all (etching baths) are directly connected. Using a cost-efficient subtractive manufacture process, the accuracy of the metal traces (etching factors, line/space ratios) obtained by the conventional etching modules may not be sufficient for a plurality of applications. Semi-additive processes may lead to more accurate metal traces, however, these processes also require more cost and effort.

It has been surprisingly found by the inventors that a more accurate and cost-efficient component carrier preform etching (for example regarding the etching factor) can be enabled, when the etching modules are operated individually to thereby take into account specific parameters and compositions, and provide a feedback functionality by communicative coupling. In an example, control units of the individual etching modules may be in communication with each other (e.g. exchanging measurement data) and thereby, the whole etching process may be regulated (by itself). For example, a downstream module may compensate for an issue (e.g. a concentration is too high or too less) that happened at an upstream module. In a further example, the whole etching system may be (by a common control unit) coupled to further processes of the component carrier manufacture, for example a galvanization process and/or a lamination process. Also in this manner, a downstream process may compensate for an upstream process. Furthermore, the processes may be regulated by a process control device, in particular using an artificial intelligence algorithm.

Further, using the described technology, it has been enabled for the first time to provide a component carrier with an etching factor of 25 (in particular 50) or more (see Figures 13 and 14) by a cost-efficient subtractive manufacture process.

### Exemplary Embodiments

According to an embodiment, the first etching scheme is independent from the second etching scheme. In other words, the first etching scheme and the second etching scheme can be applied individually. Even though, the etching schemes (and the etching modules) can be operated individually and independently, they may still be controlled/regulated so that there are coordinated with each other. In other words, modules are independent but can cooperate, e.g. event-driven. For example, a concentration of a compound may be increased form one module to the next module. The supply/drain of the compound form the etching baths is, however, individual.

Individual add-on and control of elements may be possible in each etching module. Due to different dosing possibilities (such as optimization), even anisotropic geometries in subtractive etching of a component carrier preform may be possible. Due to digital networking (interconnected control units), events can be reacted-to individually per module.

In an example, each control unit may control a velocity of the respective etching module individually.

According to a further embodiment, the first etching scheme differs from the second etching scheme in at least one of the following parameters: temperature, pressure, velocity, redox factor, pH value, viscosity, surface tension, flow amount, carry-over, rinsing, conductometry, concentration, composition, one or more additives.

This may provide the advantage that (essentially) each parameter of an etching module can be chosen independently. Thereby, specific etching schemes can be realized, and, as a result, accurate (etching factor) component carrier (preform) structures.

According to a further embodiment, the first supply and/or the first drain is different from the second supply and/or second drain. In particular, the difference is at least one of dosing, chemical composition, concentration, carry-over, a specific additive, in particular an inhibitor.

By providing each module with its own supply/drain, the chemical composition of the corresponding etching bath/solution may be individually prepared. For example, an inhibitor may only be added to the most process-downstream module, wherein already a lot of material has been etched away, so that an inhibitor may be especially useful for fine-tuning.

By providing each module with its own supply/drain, a pre-etching step (e.g. roughening the surface), an etching step (e.g. for quickly etching most of the metal) and a fine-tuning etching step (e.g. protecting the flanks of the metal traces to prevent under etching) may be realized. Thus, a three-step etching process can be performed.

According to a further embodiment, a first metal ion, in particular copper, concentration in the first etching module is different from a second metal ion, in particular copper, concentration in the second etching module.

According to a further embodiment a first acid, in particular hydrochloric acid, concentration in the first etching module is different from a second acid, in particular hydrochloric acid, concentration in the second etching module.

The metal concentration and the concentration of the etching solution (in particular acid) may be seen as especially important in the context of an etching system. Different etching stages may be efficiently established when the concentration/composition of the etching solution is varied. For example, the amount of acid may be reduced in the process-downstream direction.

According to a further embodiment a first additive, in particular an inhibitor, concentration in the first etching module is different from a second additive, in particular an inhibitor, concentration in the second etching module.

According to a further embodiment, the etching system is configured so that a first etching solution of the first etching module, and a second etching solution of the second etching module do not mix with each other during operation (in particular the first etching bath and the second etching bath are thermally decoupled). This may provide the advantage that a chemical separation is obtained, so that the etching solutions may be independent from each other. In case that etching modules are arranged side-by-side, a separation wall between the etching baths may be foreseen.

According to a further embodiment, the etching system further comprises a rinsing module (this may also be an etching module) between the first etching module and the second etching module, configured so that a component carrier preform, in particular a panel, to be etched is rinsed after being etched in the first etching module and before being etched in the second etching module.

Thereby, each etching module may apply its own etching scheme (in particular etching solution composition), independent of the previous etching scheme/solution. This may hold in particular true, if different chemicals are applied before and after the rinsing step. With this manner, chemical cross-contamination may be avoided.

In an example, cleaning means such as squeegees and air knives may be applied additionally or alternatively to the rinsing (more sustainable, as no water is needed). An additional advantage of squeegees may be, that they can be applied between the modules. Thereby, not a whole module may be necessary for a rinsing step.

According to a further embodiment, the etching system is configured to perform a subtractive manufacture process. Thereby, a cost-efficient process may be applied, while a high accuracy of metal traces may be enabled.

According to a further embodiment, the etching system is configured so that an etching factor of a component carrier preform or component carrier after etching, using the subtractive manufacture process, is 15 or larger, in particular 20 or larger, more in particular 30 or larger, more in particular 40 or larger, more in particular 50 or larger, more in particular 60 or larger, more in particular 70 or larger. This may provide the advantage that highly accurate component carriers can be produced with a subtractive process, which has not been possible so far.

According to a further embodiment, the etching system is configured so that a line/space ratio of a component carrier preform or component carrier after etching, using the subtractive manufacture process, is one or more.

According to a further embodiment, the etching system is configured so that height and width of a component carrier preform or component carrier a metal trace after etching, using the subtractive manufacture process, are essentially equal (e.g. both around 30 µm or 50 µm).

These features may also provide the advantage that highly accurate component carriers can be produced with a subtractive process, which has not been possible so far.

According to a further embodiment, the etching system is configured to trace individual panels. According to a further embodiment, the first control unit and/or the second control unit is configured to trace individual panels. Thereby, the efficiency and logistics of component carrier manufacturing may be improved.

According to a further embodiment, the etching system, further comprises: a first measurement device (e.g. a sensor), coupled to the first control unit, configured to determine first measurement data indicative of the first etching scheme.

According to a further embodiment, the etching system, further comprises a second measurement device, coupled with the second control unit, configured to determine second measurement data indicative of the second etching scheme.

The measurement data are experimental and may thus be used to efficiently feed-back data for regulating the process. Parameters to be monitored may include for example redox potential, conductance measurements, pH measurements, flow rate (filter), temperature, etc.

According to a further embodiment, the first measurement data and/or the second measurement data are indicative of at least one of a (metal, e.g. copper) concentration and/or volume, an etching solution/bath (e.g. hydrochloric acid) concentration and/or volume, a redox factor, a pH, an information with respect to a component carrier preform, a temperature, a pressure, a velocity, a flow amount, a carry-over, a rinsing, a conductometry, a viscosity, a surface tension, a chemical concentration, an amount of an additive.

This may provide the advantage that an efficient and accurate regulation based on experimental data is enabled. For example, it may be desirable to keep the hydrochloric acid concentration low in specific examples. In case that not enough metal is etched away, however, an acid concentration may be increased in a process-downstream module.

According to a further embodiment, the first control unit and the second control unit are configured to provide a coordinated control scheme, in particular using an artificial intelligence functionality.

In an example, the control units (they may also be enabled to regulate) may be connected (or implemented together) to form a common/central control unit. The common control unit may in an example coordinate all etching modules of the etching system. However, in this case, the common control unit is configured to control/regulate each etching module individually (so that there are at least two control units). Providing an AI algorithm, the system may constantly learn and improve the efficiency and accuracy.

According to a further embodiment, the first/second control unit is configured to feed forward the first/second measurement data to a process downstream control unit. According to a further embodiment, the first/second control unit is configured to feed back the first/second measurement data to a process upstream control unit. These measures may enable an especially efficient regulation and coordinated etching process.

According to a further embodiment, the second etching module is configured to compensate for an issue that occurs in the first etching module. Also this measure may enable an especially efficient regulation and coordinated etching process.

Examples for such issues repairs may include parameter deviations from previous modules, e.g. redox factor in the upstream module lower, therefore less etching progress. The process-downstream modules may then compensate, for example, the flow rates are changed when the redox factor falls.

According to a further embodiment, a process downstream etching module is configured to compensate for an issue that occurs in a process upstream etching module, and/or the process upstream etching module is configured to compensate for an issue that will occur in the process downstream etching module.

According to a further embodiment, the etching system further comprises a central control unit that controls at least two of the first control unit, the second control unit, and a further control unit.

According to a further embodiment, the etching system is configured to perform an energy save mode (software) in which the operation of the first etching module and/or the second etching module is reduced or turned off. Thereby, energy cost may be saved. For example, the first module provides the second module with the information that no panel is etched at a specific time point. Then, pumps can be reduced or turned off.

According to a further embodiment, the first etching module comprises a first plurality of first nozzles, and the first control unit (and/or the central control unit) is configured to control/regulate at least one first nozzle individually (in particular a plurality of nozzles individually, more in particular all nozzles individually) with respect to a first nozzle etching scheme (in particular the first etching scheme).

This may provide the advantage that a highly selective and accurate etching process may be provided. There may be several manners of how the amount of etching solution provided by a (spraying) nozzle can be varied individually (e.g. based on speed, pressure, amount of fluid, introducing breaks). In particular, different areas of the component carrier (preform) may be processed with the etching solution in a different manner, depending on the individual nozzle(s).

In a specific example, only the first module(s) of the system operate(s) in this manner, because process upstream the highest amount of metal may be etched away, while downstream stages may rather optimize/fine-tune the metal layer height.

According to a further embodiment, the second etching module comprises a second plurality of second nozzles, wherein the second control unit (and/or the central control unit) is configured to control/regulate at least one second nozzle individually (in particular a plurality of nozzles individually, more in particular all nozzles individually) with respect to the second nozzle etching scheme (in particular the second etching scheme), and wherein the first nozzle etching scheme is different from the second nozzle etching scheme (in particular with respect to the amount of etching solution provided).

This may provide the advantage that the nozzles of different modules may be operated in a different manner, so that highly selective and accurate etching may be enabled.

In an example, the height/thickness difference of metal layers of the component carrier (preform) may be in the range 1 to 15 µm, in particular 5 to 7 µm.

Before starting the etching process, the thickness of the metal layer(s) may be determined at different positions. This (predetermined) information may be advantageously used to adapt the nozzles of different modules (individually) to achieve a desired (uniform) height of the metal layer(s).

According to a further embodiment, the first nozzle etching scheme and/or the second nozzle etching scheme is based on a predetermined metal thickness (with respect to individual traces or the whole surface) at the component carrier (surface).

According to a further embodiment, the first nozzle etching scheme and/or the second nozzle etching scheme is configured to provide an (essentially) uniform metal thickness, in particular uniform metal thickness distribution, at the component carrier (surface).

According to a specific embodiment, the height of individual copper traces is measured previous to the etching process. Afterwards, one or more etching nozzles should target on regions where higher copper amount should be etched away to create uniform copper height (distribution) on the component carrier.

According to a further embodiment, the galvanic control unit is configured to feed forward galvanic data, in particular regarding galvanized layer thickness and/or galvanized volume, to the etching control unit.

In the context of this document, the term "galvanic (plating) process" may in particular denote a process within a circuit board and/or substrate manufacture wherein plating is performed. Plating may denote the electrochemical deposition of metallic precipitates on devices. As device serves a circuit board and/or a substrate on which the metallic precipitate (e.g. copper) may serve as electrically conductive layer structure and conductor trace, respectively, for example. Furthermore, e.g. holes (vias) can be made electrically conductive by laterally plating them or by completely filling them by plating. In an example, a current is applied to an electrolytic bath. At the positive pole (anode), the metal which shall be disposed (stripped) is located (e.g. copper or nickel), at the negative pole (cathode), the object to be coated is located (e.g. a circuit board). By the electric current, the metal ions deposit on the object by reduction. In an example, this process may be realized as a sequence of electrolytic baths. The plating process may be performed continuously or discontinuously (in a batch-wise manner).

The galvanic process may be in the component carrier manufacture process-upstream of the etching process. In particular, electrically conductive layers provided by the plating process may be further etched in the etching process for providing the etched electrically conductive structures of specific geometries. Galvanic data may in particular contain (measured, experimental) data with respect to the galvanic process, for example information regarding the plated (metal) layers/structures, layer thickness, the plated volume, etc. Additionally, issue or failures may be reported.

According to a further embodiment, the etching central control unit is configured to feed back etching data, in particular etched volume and/or etching factor, to the galvanic control unit. In turn, the etching central control unit may provide etching related measurement data to the galvanic control unit, so that the plating process may be adapted accordingly.

According to a further embodiment, the etching central control unit is configured to feed forward etching data, in particular etched volume and/or etching factor, to the lamination control unit. The etching central control unit may provide etching related measurement data to the lamination control unit, so that the lamination process may be adapted accordingly.

According to a further embodiment, the lamination control unit is configured to feed back lamination data to the etching control unit. In the context of the present document, the term "lamination process" may in particular denote a process of laminating of the etched component carrier preform with at least one further layer structure. The lamination may be accompanied by pressure and/or heat (e.g. so-called hot-press). Lamination may be done with electrically insulating layers such as prepreg. Thereby, a layer build-up for a multilayer component carrier may be realized. Lamination data may include number of layers to be laminated and structure/thickness of these layers.

According to a further embodiment, a process downstream system is configured to compensate for an issue that occurs in a process upstream system, and/or the process upstream system is configured to compensate for an issue that will occur in the process downstream system.

According to a further embodiment, the galvanic control unit and the lamination control unit may also be coupled communicatively. Data exchange may be via the etching control unit or independent of the etching control unit.

According to a further embodiment, the method further comprises: providing a specific additive, in particular at least one of a wetting agent, a brightener, an inhibitor, to only one of the first etching module and the second etching module. Specific additives may only be needed or may even be only efficient at a specific time point of the etching process. In an example, an inhibitor is only applied process-downstream, when already a lot of metal is etched and fine-tuning is desired.

According to a further embodiment, the method further comprises providing anisotropic geometries by the etching. In this manner, highly specific etching structures may be realized.

According to a further embodiment, the method further comprises: providing the component carrier preform to a third etching module, thereby i) applying a third etching scheme and ii) supplying and/or draining the third etching module. In particular, the first etching scheme comprises a pre-etching, the second etching scheme comprises an etching, and the third etching scheme comprises addition of an inhibitor.

According to a further embodiment of the component carrier (preform), the plurality of metal traces comprises a line/space ratio of one or more, and/or the height and width of the plurality of metal traces are (essentially) equal.

According to an exemplary embodiment of the (software-based) process control device, the database collects data from the running process (process parameters), respectively accesses values from a previous process step (process parameters), and thus archives (all) "actual"-values. A data model and multiple data models which are depending on each other, respectively, (which are stored in the data model unit, e.g. also in form of a database) include, amongst others, "target"-values (and "target"-ranges), optionally also their relations and variables (e.g. data models as reference values/reference models which are used for verification of the "actual"-values). The calculation device compares the "actual"-values with the "target"-values (respectively performs a calculation step based on the data models in combination with the "actual"-values) and subsequently sets an action (control operation) corresponding to the comparison result (e.g. "actual"-value corresponds to the "target"-value, "actual"-value deviates from the "target"-value, "actual"-value fulfills specific criteria, etc.). The determined control operation may comprise (at least a part of) a method step as described above.

According to an exemplary embodiment, the calculation device comprises a self-learning algorithm (AI) (e.g. realized by neuronal networks) for comparing and/or for determining. The self-learning algorithm is adapted to automatically perform the determined control operation and/or to provide it to a user for verification. Furthermore, the self-learning algorithm is adapted, based on the comparison, to determine a new predetermined process parameter and to automatically supply it to the data model unit and/or to provide it to the user for verification. Preferably, the self-learning algorithm is adapted to use the result of the verification by the user as a basis for learning. According to an exemplary embodiment, the calculation unit comprises a self-learning algorithm which sets actions (control operations) which are either directly implemented in the system, or are provided to the operator for verification. In addition, the decision of the operator at the verification may in turn form the basis for learning for the AI-function. Furthermore, based on the captured "actual"-values, the AI may create and suggest, respectively, new "target"-values/ranges which are taken into the data model either in an automatic or in an operator-controlled manner. wherein the calculation device comprises a self-learning algorithm, in particular by neuronal networks, for comparing and/or for determining;

According to an exemplary embodiment, the self-learning algorithm is adapted to, based on the comparing, determine a new predetermined process parameter and automatically supply it to the data model unit.

According to an exemplary embodiment, the self-learning algorithm is adapted to, based on the comparing, determine a new predetermined process parameter and to provide it to the user for verification.

According to an exemplary embodiment, the self-learning algorithm is adapted for using the result of the verification by the user as a basis for learning.

According to a further exemplary embodiment, there is provided a heat isolation structure (e.g. wall) between the first etching module and the second etching module. If the physically separate baths share a combined wall and if one bath has a higher temperature, there may be a heat transfer from the hotter bath to the colder. In an example, the colder bath may reach the same temperature as the hotter bath over time. This issue may be efficiently overcome by the heat insulation. In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure and/or the metal trace(s) comprise(s) at least one of the group consisting of copper, aluminum, nickel, silver, gold, palladium, tungsten, platinum (doped) silicon, carbon and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a side view of an etching system according to an exemplary embodiment of the invention.
Figure 2 shows a side view of an etching system according to another exemplary embodiment of the invention.
Figure 3 shows a side view of an etching system with respect to different module parameters according to an exemplary embodiment of the invention.
Figure 4 shows an etching scheme obtained by communicatively coupled etching modules according to an exemplary embodiment of the invention.
Figure 5 shows a component carrier preform after etching according to another exemplary embodiment of the invention.
Figure 6 shows the common definition of the etching factor.
Figure 7 shows a component carrier manufacture system according to an exemplary embodiment of the invention.
Figure 8 shows a conventional etching module.
Figure 9 shows a conventional etching bath.
Figure 10 shows a panel after etching with a conventional etching scheme.
Figure 11 shows a conventional subtractive manufacture process.
Figure 12 shows a conventional semi-additive process.
Figure 13 shows a component carrier according to an exemplary embodiment of the invention with an etching factor of 70.
Figure 14 shows a component carrier according to an exemplary embodiment of the invention with an etching factor of 50.

### Detailed Description of the Drawings

The illustrations in the drawings are schematic. In different drawings, similar or identical elements are provided with the same reference signs.

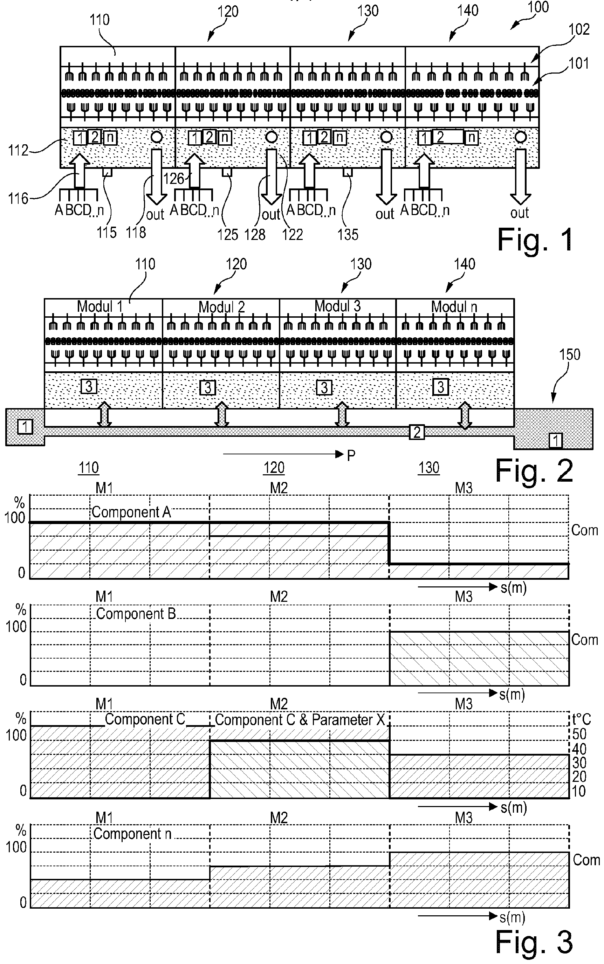

**Figure 1** shows an etching system 100 for component carrier manufacturing according to an exemplary embodiment of the invention. The etching system 100 comprises four etching modules 110, 120, 130, 140. One of these modules can be applied for cleaning/rinsing purposes only (to reduce cross-contamination). The first etching module 110 has a first control unit 115 for applying a first etching scheme, a first inlet 116 for a first supply, and a first outlet 118 for a first drain (of a first etching bath 112 with a first etching solution). The second etching module 120 has a second control unit 125 for applying a second etching scheme, a second inlet 126 for a second supply, and a second outlet 128 for a second drain (of a second etching bath 122 with a second etching solution). The third module 130 and the fourth module 140 also comprise respective control units and supplies/drains for the etching baths.

In order to avoid cross-contamination, the etching modules can comprise more than one inlet. After each dosing step, a back-flush step can be performed to clean the inlet(s). Alternatively, a mixing tank can be used in front of each etching module (controlled by the respective control unit). Thereby, only a single inlet for chemical supply may be used per etching module.

Each module 110, 120, 130, 140 comprises a transport element 101 in form of a conveyor belt for transporting (guiding) a component carrier preform such as a (printed circuit board or IC substrate) panel. The transport element 101 can be continuous through the modules or can be individual for each module. Further, each etching module 110, 120, 130, 140 comprises an etching solution application device 102 for applying the etching solution (e.g. including copper chloride or iron chloride) from the etching bath 112, 122 to the component carrier preform to be etched. In the example shown, there are respectively etching solution application devices 102 arranged above and below the transport element 101. In this manner, both opposed main surfaces of the preform can be etched at the same time.

The process direction P is from the first module 110 to the last module 140, thus, for example, the second etching module 120 is arranged process-downstream to the first etching module 110, while the third etching module 130 is arranged process-upstream of the fourth etching module 140. The first etching module 110 and the second etching module 120 are physically separated, i.e. they can be operated (for example regarding physical/chemical parameters, chemical composition, etc.) independently, in particular using different etching schemes. The same holds true for the third module 130 and the fourth module 140.

Each module comprises an etching bath, for example, the first etching module 110 comprises a first etching bath 112, while the second etching module 120 comprises a second etching bath 122. It can be seen that each module comprises its own chemical supply 116, 126 and its own chemical drain 118, 128. The baths 112, 122 are designed so that they are physically separated and do essentially not mix.

**Figure 2** shows an etching system 100 according to another exemplary embodiment of the invention. The system is very similar to the one described for Figure 1. The difference being that the control units 115, 125 of the individual etching modules are coupled with each other. Specifically, the control units 115, 125 are arranged along a connection line to form a common control unit 150 of the etching system 100. In this manner, each etching module 115, 125 can be controlled individually, while all etching modules together can also be controlled/regulated all together. Thereby, a feedback mode is enabled, so that downstream modules may compensate for issues (e.g. too low or too high concentrations) of upstream modules. The process direction is shown by reference sign P.

The first control unit 115 and the second control unit 125 are configured to provide a coordinated control scheme, e.g. using an artificial intelligence functionality. Further, the first control unit 110 is configured to feed forward the first measurement data to the second control unit 120, while the second control unit 120 is configured to feed back the second measurement data to the first control unit 110. In this manner, the second etching module 120 can compensate for an issue that occurs in the first etching module 110.

**Figure 3** shows an etching system 100 with respect to different module parameters according to an exemplary embodiment of the invention. In all four examples, there is used the above described etching system 100 with three etching modules 110, 120, 130. It can be seen that each module applies a different etching (control) scheme.

In the first example, the concentration of component A is similar in the first etching module 110 and the second etching module 120, while it is decreased in the third etching module 130. The component A (e.g. hydrochloric acid) can also be progressively reduced.

In the second example, component B is not used in the first etching module 110 and the second etching module 120, but is added in a high concentration to the third etching module 130. Component B (e.g. an inhibitor) may be only applied in the last section.

In the third example, a high concentration of component C is applied in the first etching module 110 and the second etching module 120. The parameter "temperature" is increased in the second etching module 120 to 40°C, because component C is most effective at these conditions. Then, the concentration of C is lowered for the third etching module 130 and the temperature is decreased as well.

In the fourth example, the concentration of component n is continuously increased from the first etching module 110 to the third etching module 130 (increases during process time).

**Figure 4** shows an etching scheme obtained by communicatively coupled etching modules 110, 120 according to an exemplary embodiment of the invention. Each diagram represents a specific volume of one of the etching modules over time. The diagrams above show three subsequent etching modules that do not communicate with each other. The diagrams below, in contrast, show three subsequent etching modules that communicate with each other. It can be seen that an efficient regulation scheme is obtainable by measurement data exchange and subsequent compensation by process-downstream modules.

**Figure 5** shows a component carrier preform after etching according to an exemplary embodiment of the invention. Electrically conductive, trapezoidal, structures have been etched at the copper at the component carrier preform main surface. Figure 5a shows the perform after a first etching step in the first etching module 110, while Figure 5b shows the preform after a second etching step in the second etching module 120. It can be seen that, after the second etching step, an etching factor of around 20 has been achieved, i.e. an accurate and reliable etching quality.

**Figure 7** shows a component carrier manufacture system 200 according to an exemplary embodiment of the invention. The system 200 comprises an etching system 100, as described above in detail, with an etching control unit 150 that couples the first control unit 115 and the second control unit 125. The system 200 further comprises a galvanic system 165 upstream of the etching system 100, comprising a galvanic control unit 160. Further, the system 200 comprises a lamination system 175 downstream of the etching system 100 comprising a lamination control unit 170. The etching control unit 150 is coupled to the galvanic control unit 160 and to the lamination control unit 170, so that (measurement) data can be exchanged.

The galvanic control unit 160 is configured to feed forward galvanic data, e.g. regarding galvanized layer thickness and/or galvanized volume, to the etching control unit 150 (and the lamination control unit 170), while the etching control unit 150 is configured to feed back etching data, e.g. etched volume and/or etching factor, to the galvanic control unit 160.

The etching control unit 150 is configured to feed forward the etching data to the lamination control unit 170, while the lamination control unit 170 is configured to feed back lamination data to the galvanic control unit 160 and the etching control unit 150.

**Figure 13** shows a component carrier 300 according to an exemplary embodiment of the invention, wherein the metal traces 310 comprise an etching factor of around 70.

**Figure 14** shows a component carrier 300 according to an exemplary embodiment of the invention, wherein the metal traces 310 comprise an etching factor of around 50.

It should be noted that the term "comprising" does not exclude other elements or steps and the "a" or "an" does not exclude a plurality. Also elements described in association with different embodiments may be combined. It should also be noted that reference signs in the claims shall not be construed as limiting the scope of the claims. Implementation of the invention is not limited to the preferred embodiments shown in the figures and described above. Instead, a multiplicity of variants are possible which use the solutions shown and the principle according to the patent even in the case of fundamentally different embodiments.
Aspect 1. An etching system (100) for component carrier manufacturing, the etching system (100) comprising:
   a first etching module (110) having:
      a first control unit (115) for applying a first etching scheme;
      a first inlet (116) for a first supply; and
      a first outlet (118) for a first drain;
   a second etching module (120), having:
      a second control unit (125) for applying a second etching scheme;
      a second inlet (126) for a second supply; and
      a second outlet (128) for a second drain;
   wherein the first etching module (110) and the second etching module (120) are physically separated;
   wherein one of the etching modules (110, 120) is arranged process-downstream to the other etching module (110, 120); and
   wherein the first control unit (115) and the second control unit (125) are communicatively coupled with each other.
2. The etching system (100) according to aspect 1,
   wherein the first etching scheme is independent from the second etching scheme.
3. The etching system (100) according to aspect 1 or 2,
   wherein the first etching scheme differs from the second etching scheme in at least one of the following parameters: temperature, pressure, velocity, redox factor, pH value, viscosity, surface tension, flow amount, carry-over, rinsing, conductometry, concentration, composition, one or more additives.
4. The etching system (100) according to any one of the preceding aspects, wherein the first supply and/or the first drain is different from the second supply and/or second drain,
   wherein the difference is at least one of dosing, chemical composition, concentration, carry-over, a specific additive, in particular an inhibitor.
5. The etching system (100) according to any one of the preceding aspects, wherein a first metal ion, in particular copper, concentration in the first etching module (110) is different from a second metal ion, in particular copper, concentration in the second etching module (120); and/or
   wherein a first acid, in particular hydrochloric acid, concentration in the first etching module (110) is different from a second acid, in particular hydrochloric acid, concentration in the second etching module (120); and/or
   wherein a first additive, in particular an inhibitor, concentration in the first etching module (110) is different from a second additive, in particular an inhibitor, concentration in the second etching module (120).
6. The etching system (100) according to any one of the preceding aspects, configured so that a first etching bath (112) of the first etching module (110), and a second etching bath (122) of the second etching module (120) do not mix with each other during operation,
   in particular wherein the first etching bath (112) and the second etching bath (122) are thermally decoupled.
7. The etching system (100) according to any one of the preceding aspects, further comprising:
   a rinsing module between the first etching module (110) and the second etching module (120), configured so that a component carrier preform, in particular a panel, to be etched is rinsed after being etched in the etching module (110, 120) being process upstream and before being etched in the etching module (110, 120) being process downstream.
8. The etching system (100) according to any one of the preceding aspects, wherein the etching system (100) is configured to perform a subtractive manufacture process.
9. The etching system (100) according to aspect 8, configured so that an etching factor of a component carrier preform or component carrier (300) after etching, using the subtractive manufacture process, is 15 or larger, in particular 50 or larger.
10. The etching system (100) according to aspect 8 or 9,
   configured so that a line/space ratio of a component carrier preform or component carrier (300) after etching, using the subtractive manufacture process, is one or more.
11. The etching system (100) according to any one of the aspects 8 to 10, configured so that height and width of a component carrier preform or component carrier (300) a metal trace (310) after etching, using the subtractive manufacture process, are essentially equal.
12. The etching system (100) according to any one of the preceding aspects, wherein the etching system (100) is configured to trace individual panels; and/or wherein the first control unit (115) and/or the second control unit (125) is configured to trace individual panels.
13. The etching system (100) according to any one of the preceding aspects, further comprising:
   a first measurement device, coupled to the first control unit (115), configured to determine first measurement data indicative of the first etching module (110); and/or
   a second measurement device, coupled to the second control unit (125), configured to determine second measurement data indicative of the second etching module (120).
14. The etching system (100) according to aspect 13,
   wherein the first measurement data and/or the second measurement data are indicative of at least one of a metal concentration and/or volume, an etching solution concentration and/or volume, a redox factor, a pH value, an information with respect to a component carrier preform, a temperature, a pressure, a velocity, a flow amount, a carry-over, a rinsing, a conductometry, a viscosity, a surface tension, a chemical concentration, an amount of an additive.
15. The etching system (100) according to any one of the preceding aspects, wherein the first control unit (115) and the second control unit (125) are configured to provide a coordinated control scheme.
16. The etching system (100) according to aspect 15,
   wherein the first control unit (115) and the second control unit (125) are configured to provide the coordinated control scheme using an artificial intelligence functionality.
17. The etching system (100) according to any one of the preceding aspects, wherein the first control unit (115) and/or the second control unit (125) is configured to feed forward measurement data to a control unit (115, 125, 135) being process downstream; and/or
   wherein the first control unit (115) and/or the second control unit (125) is configured to feed backward measurement data to a control unit (115, 125, 135) being process upstream.
18. The etching system (100) according to any one of the preceding aspects, further comprising:
   a central control unit (150) that controls at least two of the first control unit (115), the second control unit (125), and a further control unit (135).
19. The etching system (100) according to any one of the preceding aspects, wherein a process downstream etching module (110, 120) is configured to compensate for an issue that occurs in a process upstream etching module (110, 120); and/or
   wherein the process upstream etching module (110, 120) is configured to compensate for an issue that will occur in the process downstream etching module (110, 120).
20. The etching system (100) according to any one of the preceding aspects, configured to perform an energy save mode in which the operation of the first etching module (110) and/or the second etching module (120) is reduced or turned off.
21. The etching system (100) according to any one of the preceding aspects, wherein the first etching module (110) comprises a first plurality of first nozzles (113), and
   wherein the first control unit (115) is configured to control at least one first nozzle individually with respect to a first nozzle etching scheme.
22. The etching system (100) according to aspect 21,
   wherein the second etching module (120) comprises a second plurality of second nozzles (123),
   wherein the second control unit (125) is configured to control at least one second nozzle individually with respect to the second nozzle etching scheme, and
   wherein the first nozzle etching scheme is different from the second nozzle etching scheme, in particular with respect to the amount of etching solution.
23. The etching system according to aspect 21 or 22,
   wherein the first nozzle etching scheme and/or the second nozzle etching scheme is based on a predetermined metal thickness at the component carrier.
24. The etching system according to any one of aspects 21 to 23,
   wherein the first nozzle etching scheme and/or the second nozzle etching scheme is configured to provide an essentially uniform metal thickness, in particular uniform metal thickness distribution, at the component carrier.
Aspect 25. A component carrier manufacture system (180), comprising:
   an etching system (100) as described in any one of the preceding aspects, comprising an etching central control unit (150) that couples the first control unit (115) and the second control unit (125); and
   at least one of the following:
      a galvanic system (165) process-upstream of the etching system (100), comprising a galvanic control unit (160);
      a lamination system (175) process-downstream of the etching system (100) comprising a lamination control unit (170);
      wherein the etching central control unit (150) is coupled with the galvanic control unit (160) and/or the lamination control unit (170).
26. The component carrier manufacturing system (180) according to aspect 25,
   wherein the galvanic control unit (160) is configured to feed forward galvanic data, in particular regarding galvanized layer thickness and/or galvanized volume, to the etching central control unit (150); and/or
   wherein the etching central control unit (150) is configured to feed back etching data, in particular etched volume and/or etching factor, to the galvanic control unit (160).
27. The component carrier manufacturing system (180) according to aspect 25 or 26,
   wherein the etching central control unit (150) is configured to feed forward etching data, in particular etched volume and/or etching factor, to the lamination control unit (170); and/or
   wherein the lamination control unit (170) is configured to feed back lamination data to the etching central control unit (150).
28. The component carrier manufacturing system (180) according to any one of aspects 25 to 27,
   wherein a process downstream system (100, 165, 175) is configured to compensate for an issue that occurs in a process upstream system (100, 165, 175); and/or
   wherein the process upstream system (100, 165, 175) is configured to compensate for an issue that will occur in the process downstream system (100, 165, 175).
Aspect 29. Using physically separated and communicatively coupled etching modules (110, 120) to obtain an etching factor of 15 or more, in particular 50 or more, using a subtractive manufacture process, in a component carrier preform or component carrier (300).
Aspect 30. A method of etching a component carrier preform in a component carrier manufacture, the method comprises:
   providing the component carrier preform to a first etching module (110); thereby
   applying a first etching scheme; and
   supplying and/or draining the first etching module (110); and then providing the component carrier preform to a second etching module (120); thereby
   applying a second etching scheme; and
   supplying and/or draining the second etching module (120);
   wherein the first etching module (110) and the second etching module (120) are physically separated, and
   wherein the first etching module (110) and the second etching module (120) are communicatively coupled.
31. The method according to aspect 30, further comprising:
   providing a specific additive, in particular an inhibitor, to only one of the first etching module (110) and the second etching module (120).
32. The method according to aspect 30 or 31, further comprising:
   providing anisotropic geometries for the component carrier preform or component carrier by the etching.
33. The method according to any of the aspects 30 to 32, further comprising:
   providing the component carrier preform to a third etching module (130); thereby
   applying a third etching scheme; and
   supplying and/or draining the third etching module (130);
   in particular wherein the first etching scheme comprises a pre-etching, wherein the second etching scheme comprises an etching, and wherein the third etching scheme comprises addition of an inhibitor.
Aspect 34. A component carrier (300), manufactured by a subtractive manufacture process, comprising:
   a plurality of electrically insulating layer structures and/or electrically conductive layer structures; and
   at least one metal trace (310), wherein the metal trace (310) comprises an etching factor of 25 or more, in particular 50 or more;
   wherein the component carrier (300) is free of a seed layer (266) that reflects a semi-additive process, SAP.
35. The component carrier (300) according to aspect 34,
   wherein the at least one metal trace (310) comprises a line/space ratio of one or more.
36. The component carrier (300) according to aspect 34 or 35,
   wherein the height and width of the metal trace (310) is essentially equal.
Aspect 37. A process control device for regulating at least one of a system (100) according to any one of the aspects 1 to 24, a component carrier manufacturing system according to any one of the aspects 25 to 29, a method according to any one of the aspects 30 to 33, wherein the process control device comprises:
   a database for capturing at least one process parameter of the running process;
   a data model unit which is adapted for storing at least one predetermined process parameter; and
   a calculation device which is adapted for
      comparing the captured process parameter with the predetermined process parameter,
      determining a control operation which is based on the result of the comparison, and
      performing the determined control operation.
38. The process control device according to aspect 37, further comprising at least one of the following features:
   wherein the calculation device comprises a self-learning algorithm, in particular by neuronal networks, for comparing and/or for determining;
   wherein the self-learning algorithm is adapted for automatically performing the determined control operation, and/or
   wherein the self-learning algorithm is adapted for providing the determined control operation to a user for verification;
   wherein the self-learning algorithm is adapted to, based on the comparing, determine a new predetermined process parameter and automatically supply it to the data model unit and/or
   wherein the self-learning algorithm is adapted to, based on the comparing, determine a new predetermined process parameter and to provide it to the user for verification;
   wherein the self-learning algorithm is adapted for using the result of the verification by the user as a basis for learning.
Aspect 39. A computer program product for controlling component carrier manufacture, which computer program product, when it is executed by one or more processors, controls and/or regulates at least one of a system (100) according to any one of the aspects 1 to 24, a component carrier manufacturing system according to any one of the aspects 25 to 29, a method according to any one of the aspects 30 to 33.

### Reference signs

- 100: Etching system
- 101: Transport element
- 102: Etching solution application device
- 110: First etching module
- 112: First bath
- 115: First control unit
- 116: First inlet
- 118: First outlet
- 120: Second etching module
- 122: Second bath
- 125: Second control unit
- 126: Second inlet
- 128: Second outlet
- 130: Third etching module
- 135: Further control unit
- 140: Fourth etching module
- 150: Etching central control unit
- 160: Galvanic control unit
- 165: Galvanic system/process
- 170: Lamination control unit
- 175: Lamination system/process
- 180: Component carrier manufacture system
- 200, 210, 220, 230: Conventional modules
- 216: Conventional common inlet
- 218: Conventional common outlet
- 260: Thick copper layer
- 261: Photoresist
- 262: Copper trace (subtractive process)
- 263: Under-etch
- 265: Thin copper layer
- 266: Seed layer
- 267: Copper plating
- 268: Copper trace (additive process)
- 300: Component carrier
- 310: Metal trace

## Claims

1. An etching system (100) for component carrier manufacturing, the etching system (100) comprising:
a first etching module (110) having:
a first control unit (115) for applying a first etching scheme;
a first inlet (116) for a first supply; and
a first outlet (118) for a first drain;
a second etching module (120), having:
a second control unit (125) for applying a second etching scheme;
a second inlet (126) for a second supply; and
a second outlet (128) for a second drain;
wherein the first etching module (110) and the second etching module (120) are physically separated;
wherein one of the etching modules (110, 120) is arranged process-downstream to the other etching module (110, 120); and
wherein the first control unit (115) and the second control unit (125) are communicatively coupled with each other.

2. The etching system (100) according to claim 1,
wherein the first etching scheme is independent from the second etching scheme; and/or
wherein the first etching scheme differs from the second etching scheme in at least one of the following parameters: temperature, pressure, velocity, redox factor, pH value, viscosity, surface tension, flow amount, carry-over, rinsing, conductometry, concentration, composition, one or more additives; and/or
wherein the first supply and/or the first drain is different from the second supply and/or second drain,
wherein the difference is at least one of dosing, chemical composition, concentration, carry-over, a specific additive, in particular an inhibitor; and/or
wherein a first metal ion, in particular copper, concentration in the first etching module (110) is different from a second metal ion, in particular copper, concentration in the second etching module (120); and/or
wherein a first acid, in particular hydrochloric acid, concentration in the first etching module (110) is different from a second acid, in particular hydrochloric acid, concentration in the second etching module (120); and/or
wherein a first additive, in particular an inhibitor, concentration in the first etching module (110) is different from a second additive, in particular an inhibitor, concentration in the second etching module (120).

3. The etching system (100) according to claim 1 or 2, configured so that a first etching bath (112) of the first etching module (110), and a second etching bath (122) of the second etching module (120) do not mix with each other during operation,
in particular wherein a first chemical composition of the first etching bath (112) is different from a second chemical composition of the second bath (122), more in particular wherein the first etching bath (112) and the second etching bath (122) are thermally decoupled.

4. The etching system (100) according to any one of the preceding claims, wherein the etching system (100) is configured to perform a subtractive manufacture process, so that:
an etching factor of a component carrier preform or component carrier (300) after etching, using the subtractive manufacture process, is 15 or larger, in particular 50 or larger; and/or
a line/space ratio of a component carrier preform or component carrier (300) after etching, using the subtractive manufacture process, is one or more; and/or
height and width of a component carrier preform or component carrier (300) metal trace (310) after etching, using the subtractive manufacture process, are essentially equal.

5. The etching system (100) according to any one of the preceding claims, further comprising:
a first measurement device, coupled to the first control unit (115), configured to determine first measurement data indicative of the first etching module (110); and/or
a second measurement device, coupled to the second control unit (125), configured to determine second measurement data indicative of the second etching module (120),
in particular wherein the first measurement data and/or the second measurement data are indicative of at least one of a metal concentration and/or volume, an etching solution concentration and/or volume, a redox factor, a pH value, an information with respect to a component carrier preform, a temperature, a pressure, a velocity, a flow amount, a carry-over, a rinsing, a conductometry, a viscosity, a surface tension, a chemical concentration, an amount of an additive.

6. The etching system (100) according to any one of the preceding claims,
further comprising: a rinsing module between the first etching module (110) and the second etching module (120), configured so that a component carrier preform, in particular a panel, to be etched is rinsed after being etched in the etching module (110, 120) being process upstream and before being etched in the etching module (110, 120) being process downstream; and/or
wherein the etching system (100) is configured to trace individual panels; and/or
wherein the first control unit (115) and/or the second control unit (125) is configured to trace individual panels; and/or
wherein the first control unit (115) and the second control unit (125) are configured to provide a coordinated control scheme,
in particular wherein the first control unit (115) and the second control unit (125) are configured to provide the coordinated control scheme using an artificial intelligence functionality; and/or
further comprising:
a central control unit (150) that controls at least two of the first control unit (115), the second control unit (125), and a further control unit (135); and/or
configured to perform an energy save mode in which the operation of the first etching module (110) and/or the second etching module (120) is reduced or turned off.

7. The etching system (100) according to any one of the preceding claims,
wherein the first control unit (115) and/or the second control unit (125) is configured to feed forward measurement data to a control unit (115, 125, 135) being process downstream; and/or
wherein the first control unit (115) and/or the second control unit (125) is configured to feed backward measurement data to a control unit (115, 125, 135) being process upstream; and/or
wherein a process downstream etching module (110, 120) is configured to compensate for an issue that occurs in a process upstream etching module (110, 120); and/or
wherein the process upstream etching module (110, 120) is configured to compensate for an issue that will occur in the process downstream etching module (110, 120).

8. The etching system (100) according to any one of the preceding claims, wherein the first etching module (110) comprises a first plurality of first nozzles (113), and
wherein the first control unit (115) is configured to control at least one first nozzle individually with respect to a first nozzle etching scheme.

9. The etching system (100) according to claim 8,
wherein the second etching module (120) comprises a second plurality of second nozzles (123); and/or
wherein the second control unit (125) is configured to control at least one second nozzle individually with respect to the second nozzle etching scheme, and wherein the first nozzle etching scheme is different from the second nozzle etching scheme, in particular with respect to the amount of etching solution; and/or
wherein the first nozzle etching scheme and/or the second nozzle etching scheme is based on a predetermined metal thickness at the component carrier; and/or
wherein the first nozzle etching scheme and/or the second nozzle etching scheme is configured to provide an essentially uniform metal thickness, in particular uniform metal thickness distribution, at the component carrier.

10. A component carrier manufacture system (180), comprising:
an etching system (100) as described in any one of the preceding claims, comprising an etching central control unit (150) that couples the first control unit (115) and the second control unit (125); and
at least one of the following:
a galvanic system (165) process-upstream of the etching system (100), comprising a galvanic control unit (160);
a lamination system (175) process-downstream of the etching system (100) comprising a lamination control unit (170);
wherein the etching central control unit (150) is coupled with the galvanic control unit (160) and/or the lamination control unit (170).

11. The component carrier manufacturing system (180) according to claim 10,
wherein the galvanic control unit (160) is configured to feed forward galvanic data, in particular regarding galvanized layer thickness and/or galvanized volume, to the etching central control unit (150); and/or
wherein the etching central control unit (150) is configured to feed back etching data, in particular etched volume and/or etching factor, to the galvanic control unit (160); and/or
wherein the etching central control unit (150) is configured to feed forward etching data, in particular etched volume and/or etching factor, to the lamination control unit (170); and/or
wherein the lamination control unit (170) is configured to feed back lamination data to the etching central control unit (150); and/or
wherein a process downstream system (100, 165, 175) is configured to compensate for an issue that occurs in a process upstream system (100, 165, 175); and/or
wherein the process upstream system (100, 165, 175) is configured to compensate for an issue that will occur in the process downstream system (100, 165, 175).

12. A method of etching a component carrier preform in a component carrier manufacture, the method comprises:
providing the component carrier preform to a first etching module (110); thereby
applying a first etching scheme; and
supplying and/or draining the first etching module (110); and then providing the component carrier preform to a second etching module (120); thereby
applying a second etching scheme; and
supplying and/or draining the second etching module (120);
wherein the first etching module (110) and the second etching module (120) are physically separated, and
wherein the first etching module (110) and the second etching module (120) are communicatively coupled.

13. The method according to claim 12, further comprising:
providing a specific additive, in particular an inhibitor, to only one of the first etching module (110) and the second etching module (120); and/or
providing anisotropic geometries for the component carrier preform or component carrier by the etching; and/or
providing the component carrier preform to a third etching module (130); thereby
applying a third etching scheme, and
supplying and/or draining the third etching module (130),
in particular wherein the first etching scheme comprises a pre-etching, wherein the second etching scheme comprises an etching, and wherein the third etching scheme comprises addition of an inhibitor.

14. A component carrier (300), manufactured by a subtractive manufacture process, comprising:
a plurality of electrically insulating layer structures and/or electrically conductive layer structures; and
at least one metal trace (310), wherein the metal trace (310) comprises an etching factor of 25 or more, in particular 50 or more;
wherein the component carrier (300) is free of a seed layer (266) that reflects a semi-additive process, SAP.

15. The component carrier (300) according to claim 14,
wherein the at least one metal trace (310) comprises a line/space ratio of one or more, and/or
wherein the height and width of the metal trace (310) is essentially equal.
